(19) Europäisches Patentamt
European Patent Office
Office européen des brevets

(11) **EP 3 433 914 B1**

(12) **EUROPEAN PATENT SPECIFICATION**

(45) Date of publication and mention of the grant of the patent:
**06.04.2022 Bulletin 2022/14**

(21) Application number: **17724234.4**

(22) Date of filing: **08.05.2017**

(51) International Patent Classification (IPC):
**H02J 3/38** *(2006.01)* **G05F 1/67** *(2006.01)*
**H02S 40/36** *(2014.01)*

(52) Cooperative Patent Classification (CPC):
**G05F 1/67; H01L 31/042; H02J 3/381; H02J 3/46;**
H02J 2300/26; Y02E 10/56

(86) International application number:
**PCT/US2017/031571**

(87) International publication number:
**WO 2017/196735 (16.11.2017 Gazette 2017/46)**

(54) **MAXIMIZING POWER IN A PHOTOVOLTAIC DISTRIBUTED POWER SYSTEM**

MAXIMIERUNG DER LEISTUNG IN EINEM VERTEILTEN FOTOVOLTAISCHEN STROMSYSTEM

MAXIMISATION DE L'ÉNERGIE DANS UN SYSTÈME D'ÉNERGIE PHOTOVOLTAÏQUE DISTRIBUÉE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.05.2016 US 201615149353**

(43) Date of publication of application:
**30.01.2019 Bulletin 2019/05**

(73) Proprietor: **Solaredge Technologies Ltd.**
**4673335 Herzeliya (IL)**

(72) Inventors:
• **YOSCOVICH, Ilan**
**Herzeliya 4673335 (IL)**
• **BIEBER, Ofir**
**Herzeliya 4673335 (IL)**
• **GLOVINSKY, Tzachi**
**Herzeliya 4673335 (IL)**

(74) Representative: **V.O.**
**P.O. Box 87930**
**Carnegieplein 5**
**2508 DH Den Haag (NL)**

(56) References cited:
**US-A1- 2010 126 550** **US-A1- 2013 193 765**
**US-A1- 2015 364 918**

• **HUIMIN ZHOU ET AL: "PV Balancers: Concept, Architectures, and Realization", IEEE TRANSACTIONS ON POWER ELECTRONICS, vol. 30, no. 7, 31 July 2014 (2014-07-31), pages 3479-3487, XP055387791, USA ISSN: 0885-8993, DOI: 10.1109/TPEL.2014.2343615**
• **HUIMIN ZHOU ET AL: "PV balancers: Concept, architectures, and realization", ENERGY CONVERSION CONGRESS AND EXPOSITION (ECCE), 2012 IEEE, IEEE, 15 September 2012 (2012-09-15), pages 3749-3755, XP032467286, DOI: 10.1109/ECCE.2012.6342469 ISBN: 978-1-4673-0802-1**
• **ZHAO JUNJIAN ET AL: "Analysis of high efficiency DC/DC converter processing partial input/output power", 2013 IEEE 14TH WORKSHOP ON CONTROL AND MODELING FOR POWER ELECTRONICS (COMPEL), IEEE, 23 June 2013 (2013-06-23), pages 1-8, XP032500832, ISSN: 1093-5142, DOI: 10.1109/COMPEL.2013.6626440 [retrieved on 2013-10-09]**

## Description

BACKGROUND

Photovoltaic (PV) power devices can be used to improve the performance and to reduce the cost of power generation systems including photovoltaic panels. Photovoltaic power devices can be variously configured. The cost of some power devices may be proportional to the amount of electrical power they process. Thus, significant savings can be realized by designing systems to optimize output power while processing a small portion of the system power.

Accordingly, there is a need for designing power device system with increased efficiency while decreasing the operating costs associated with such as system.

1. Technical Field

The exemplary features presented relate to a photovoltaic power harvesting system including multiple photovoltaic strings and, more particularly to system and method for maximizing power in each photovoltaic string.

2. Description of Related Art

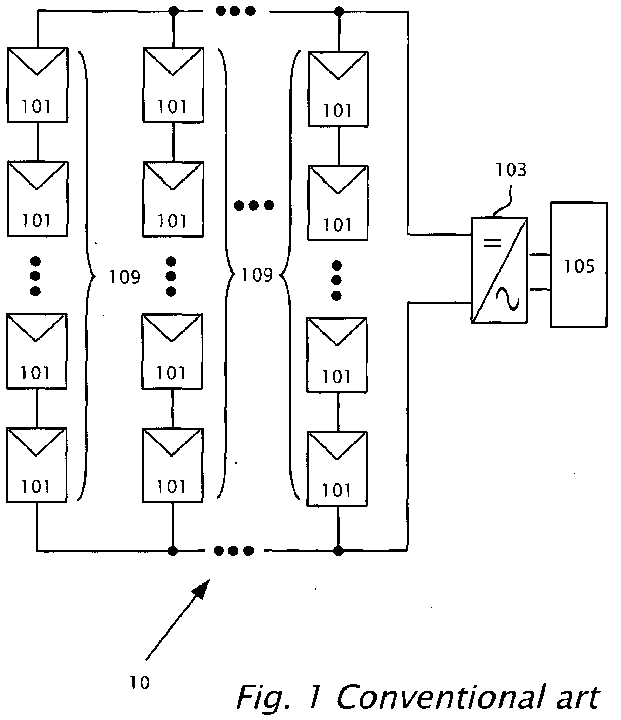

Reference is made to Fig. 1 which shows a photovoltaic power harvesting system 10 according to conventional art. A photovoltaic string 109 includes a series connection of photovoltaic panels 101. Photovoltaic strings 109 may be connected in parallel to give a parallel direct current (DC) power output. The parallel DC power output connects to the input of a direct current (DC) to alternating current (AC) inverter 103. The AC power output of inverter 103 connects across an AC load 105. AC load 105 may be an AC load such as an AC motor or may be an electrical power grid.

By way of a simplified numerical example, three strings 109 may be used with an inverter 103. If two strings 109 are equally irradiated such that each string operates with a string voltage of 600 volts (V) and string current of 10 amperes (A); each of the two strings generates (10 A · 600 V) 6 kilowatts (kW). It is also assumed that the two equally irradiated strings 109 may be operating at maximum power.

If however, one string 109 is partially shaded or if one or more panels 101 is under performing, there may still be a string voltage of 600V as set by the other two equally irradiated strings 109, however, the string current in the one under performing string 109 may only be only 6 amperes. The under performing string 109 is not operating at maximum power point. For instance, it may be that the under performing string 109 has a maximum power point of 550 volts for a current of 10 amperes. In this situation, the power lost by the under performing string 109 is 1.9kW (550V·10A - 600V·6A). The under performing string 109, therefore, produces 3.6kW (600V·6A). Overall power harvested from system 10 is, therefore 15.6kW (3.6kW + 2 · 6kW).

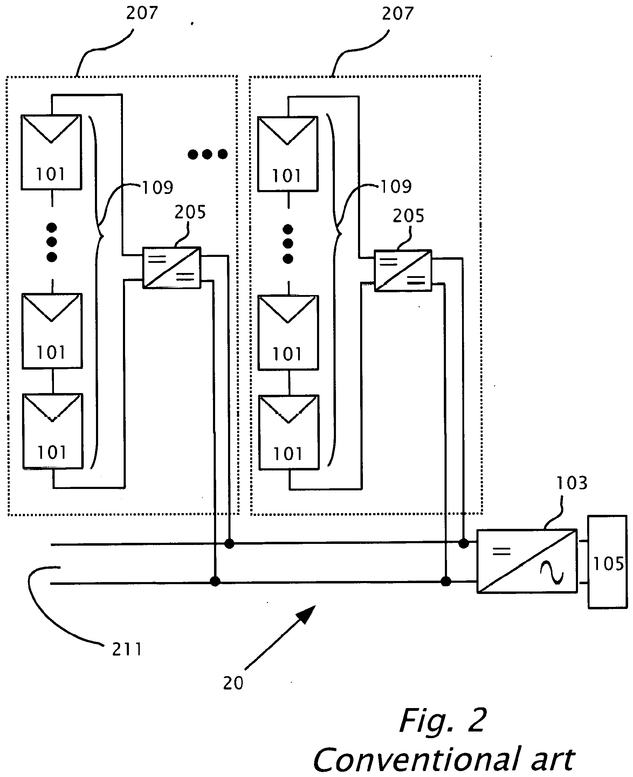

Reference is now made to Fig. 2 which shows another power harvesting system 20 according to conventional art, according to international patent application publication WO2010002960. System 20 is directed to reduce power losses compared to the losses of system 10. Each photovoltaic string 109 includes a series connection of photovoltaic panels 101. Each photovoltaic string 109 is connected in parallel to an input of a DC-to-DC converter 205. The output of converter 205 connects to a DC bus 211. The DC voltage generated by photovoltaic string 109 is converted by converter 205 to the voltage of DC bus 211. Each photovoltaic string 109 together with the respective DC-DC converter 205 forms a photovoltaic string module 207. A number of modules 207 with outputs from respective DC-to-DC converters 205 may be connected in parallel to DC bus 211. The parallel combined outputs of modules 207 may be also connected to an input of a direct current (DC) to alternating current (AC) inverter 103 via DC bus 211. Inverter 103 converts the combined DC power outputs of modules 207 to an alternating current power at an output of inverter 103. The output of inverter 103 connects to AC load 105.

Still referring to Fig. 2, using the same numerical example as in system 10 (Fig. 1), three modules 207 may be used with inverter 103. Two strings 109 may be equally irradiated such that each string of the two strings operates with a string voltage of 600 volts and string current of 10 amperes. Each of the two strings generates (10 amperes . 600 volts) or 6 kilowatts. If the one remaining string 109 is under performing, there may be maximum power point for the under performing string 109 of 550 volts and current of 10 amperes. Each DC-to-DC converter 205 may be configured to maximize power on each respective output to give 600 volts on DC bus 211. The two equally irradiated modules 207 each produce 6 kW (10 amperes· 600 volts) and the under performing unit 207 produces 5.5 kW (10 amperes · 550 volts). Giving an overall power harvested from system 20 of 17.5 kW. It can be seen that system 20 offers an improvement of 1.9kW over system 10 in terms of minimized losses and increased power harvested. The improvement has been achieved through multiple DC-DC converters 205 which operate at wattage levels of around 6 kW. The high power DC-DC converters 205 in a power harvesting system may add to the cost of installation and maintenance of the power harvesting system and may present an overall decreased level of reliability for the power harvesting system because DC-DC converters 205 operate at high wattage levels.

US2013/193765 discloses system comprising: a plurality of parallel-connected compensated photovoltaic strings, each compensated photovoltaic string including: a photovoltaic string having a series-connection of photovoltaic cells; and a voltage-compensation circuit having a voltage output connected in series with said photovoltaic string, wherein said voltage-compensation circuit includes an input connected to a source of power separate from power provided by the photovoltaic string, wherein the voltage-compensation circuit is configured to provide at the voltage output an adjustable compensation voltage in series with a voltage generated by said photovoltaic string such that a total voltage of the compensated photovoltaic string maintains a predetermined value.

HUIMIN ZHOU ET AL, "PV Balancers: Concept, Architectures, and Realization", IEEE TRANSACTIONS ON POWER ELECTRONICS, USA, vol. 30, no. 7, doi:10.1109/TPEL.2014.2343615, ISSN 0885-8993, pages 3479 - 3487, discloses PV balancers that are DC-DC converters, which are integrated into each module, and combined into a common DC bus configuration.

HUIMIN ZHOU ET AL, "PV balancers: Concept, architectures, and realization", ENERGY CONVERSION CONGRESS AND EXPOSITION (ECCE), 2012 IEEE, IEEE, doi:10.1109/ECCE.2012.6342469, ISBN 978-1-4673-0802-1, pages 3749 - 3755, discloses PV balancers that are DC-DC converters, which are integrated into each module, and combined into a common DC bus configuration.

US2010/126550 discloses an apparatus that controls the power produced by a string of solar cells, enabling the string to operate at its maximum power point when connected to a bus that operates at an externally controlled voltage. The apparatus can also be used to increase or decrease the output power of a string to any desired operating point.

US2015/364918 discloses a system for optimizing load current in a string of solar panels. A string of solar panels includes a microprocessor coupled to the string of solar panels. The system includes a first DC-to-DC converter comprising input terminals coupled to a load and output terminals coupled to each solar panel in the string of solar panels. The first DC-to-DC converter is operable to supply a compensatory power for compensating a drop in the peak current arising due to shading of one or more solar panels. Moreover, the system includes a second DC-to-DC converter coupled to the first DC-to-DC converter. The second DC-to-DC converter is operable as one of a voltage adder and a voltage subtractor to generate a compensatory voltage for compensating a drop in the load current arising due to panel mismatch among the string of solar panels.

The terms "monitoring", "sensing" and "measuring" are used herein interchangeably.

The terms "power grid" and "mains grid" are used herein interchangeably and refer to a source of alternating current (AC) power provided by a power supply company.

The term "converter" as used herein applies to DC-to-DC converters, AC-to-DC converters, DC-to-AC inverters, buck converters, boost converters, buck-boost converters, full-bridge converters and half-bridge converters or any other circuit for electrical power conversion/inversion known in the art.

The term "DC load" as used herein applies to the DC inputs of converters, batteries, DC motors or DC generators.

The term "AC load" as used herein applies to the AC inputs of converters, transformers, AC motors or AC generators.

SUMMARY

The present invention is defined in the appended claims.

BRIEF DESCRIPTION OF THE DRAWINGS

These and other features, aspects, and advantages of the present disclosure will become better understood with regard to the following description, claims, and drawings. The present disclosure is illustrated by way of example, and not limited by, the accompanying figures. A more complete understanding of the present disclosure and the advantages thereof may be acquired by referring to the following description in consideration of the accompanying drawings, in which like reference numbers indicate like features.

Fig. 1 shows a photovoltaic power harvesting system according to conventional art.
Fig. 2 shows another photovoltaic power harvesting system according to conventional art.
Fig. 3a shows a power harvesting system.
Fig. 3b shows a power harvesting system.
Fig. 3c shows more details of a voltage-compensation circuit shown in Figs. 3a and 3b not forming part of the invention as such but useful for providing an understanding thereof.
Fig. 3d shows an implementation of a voltage-compensation circuit shown in Figs. 3a and 3b not forming part of the invention.
Fig. 4 shows a method applied to the power harvesting systems shown in Figs. 3a and 3b.
Fig. 5 depicts a part schematic, part block-diagram of an exemplary power system.
Figs. 6A-6B depict schematic diagrams of exemplary isolated power converters not forming part of the invention.
Fig. 7 depicts a part schematic, part block-diagram of a compensation circuit featured in an exemplary embodiment of the invention.
Fig. 8 depicts a part schematic, part block-diagram of a compensation circuit not forming part of the present invention as such but useful for providing an understanding thereof.
Fig. 9 depicts a part schematic, part block-diagram of an exemplary power system not forming part of the invention as such but useful for providing an understanding thereof.
Fig. 10 depicts a part schematic, part block-diagram of an exemplary power system according to exemplary embodiments of the invention.

Figs. 11A-11B depict part schematic, part block-diagram illustrations of current flow through an exemplary compensation not forming part of the invention as such but useful for providing an understanding thereof.

Fig. 12 depicts a part schematic, part block-diagram of an exemplary power system not forming part of the invention.

Fig. 13 depicts a part schematic, part block-diagram of an integrated solar block not forming part of the invention.

Fig. 14 depicts a part schematic, part block-diagram of an exemplary power device not forming part of the invention.

Fig. 15 depicts a part schematic, part block-diagram of an exemplary power device not forming part of the invention.

Fig. 16 depicts an illustrative diagram showing storage of exemplary power devices not forming part of the invention.

DETAILED DESCRIPTION

In the following description of various illustrative embodiments, reference is made to the accompanying drawings, which form a part hereof, and in which is shown, by way of illustration, various embodiments in which aspects of the disclosure may be practiced. It is to be understood that other embodiments may be utilized and structural and functional modifications may be made, without departing from the scope of the present disclosure.

It should be noted, that although the discussion herein relates primarily to photovoltaic systems, the teachings disclosed herein may, by non-limiting example, alternatively be configured using other distributed power systems including (but not limited to) wind turbines, hydro turbines, fuel cells, storage systems such as battery, super-conducting flywheel, and capacitors, and mechanical devices including conventional and variable speed diesel engines, Stirling engines, gas turbines, and micro-turbines.

By way of introduction, features of the present invention are directed towards maximizing output power from under-performing or partially shaded photovoltaic strings in a power harvesting system of parallel connected photovoltaic strings. The features may provide maximal overall power output of the system and reduced installation and maintenance cost of the system. The features may also provide increased reliability of the system, owing to lower power operating levels of switching converters added to each of the photovoltaic string compared with DC-DC converters 205 used in conventional system 20.

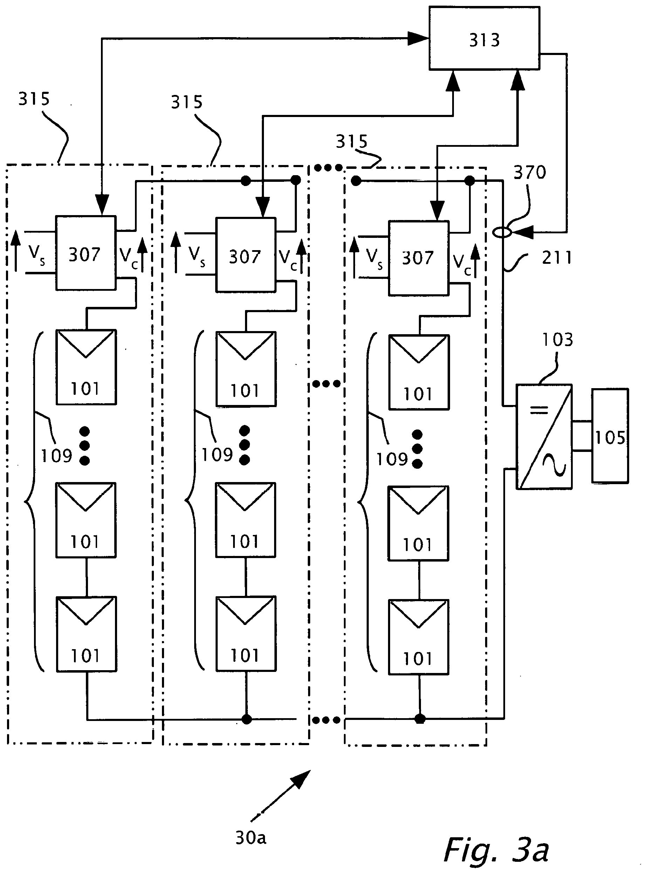

Reference is now made to Fig. 3a which shows a power harvesting system 30a according to a feature of the present invention. A number of photovoltaic panels 101 are connected in series to form a photovoltaic string 109. String 109 is connected in series with a voltage-compensation circuit 307 to provide a compensated string 315. A source voltage (Vs) may be input to voltage-compensation circuit 307. A number of compensated strings 315 are connected together in parallel to give direct current (DC) power output 211. A power sensor 370 operatively connected to central controller 313 measures the power on DC output 211. DC power output 211 is connected to an input of a DC to alternating current (AC) inverter 103. Inverter 103 converts the combined DC power output 211 of strings 315 to an alternating current power at an output of inverter 103. The output of inverter 103 connects to AC load 105. A central controller 313 may be operatively attached to each voltage-compensation circuit 307 by bi-directional control and communication lines as shown, by wireless communication or by power line communications in DC bus 211. Central controller 313 may include a microprocessor with on-board memory and an interface which may include analogue to digital converters (ADCs) and digital to analogue converters (DACs).

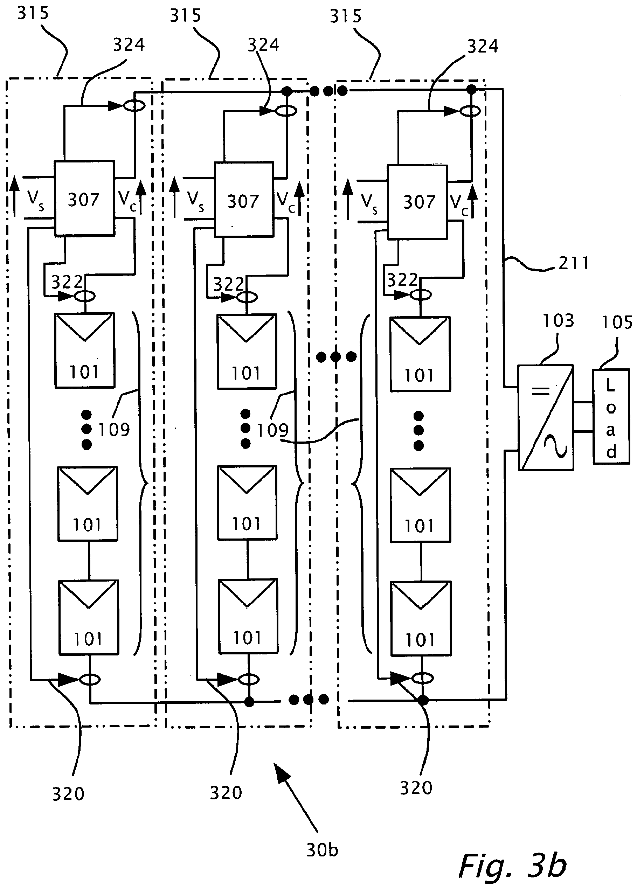

Reference is now made to Fig. 3b which shows a power harvesting system 30b according to another feature of the present invention. String 109 is connected in series with voltage-compensation circuit 307 to provide a compensated string 315. A source voltage (Vs) is input to voltage-compensation circuit 307. A number of compensated strings 315 are connected together in parallel to give direct current (DC) power output 211. DC power output 211 is connected to an input of a DC to alternating current (AC) inverter 103. Inverter 103 converts the combined DC power output 211 of strings 315 to an alternating current power at an output of inverter 103. The output of inverter 103 connects to AC load 105. System 30a is the same as system 30b except that system 30b does not have central controller 313. Instead, monitoring and control in system 30b is performed by each circuit 307, which may include a microprocessor with on-board memory and an interface which may include analogue to digital converters (ADCs) and digital to analogue converters (DACs). Each circuit 307 is operatively attached to sensors 320, 322 and 324. Sensors 320 and 322 may be adapted to sense the voltage across photovoltaic string 109 as well as current in string 109. Alternatively, sensors 320 and 324 may be adapted to sense the voltage across a compensated string 315 and current in string 315. Alternatively, sensors 324 and 322 may be adapted to sense the voltage (Vc) across a circuit 307 as well as current through the circuit 307.

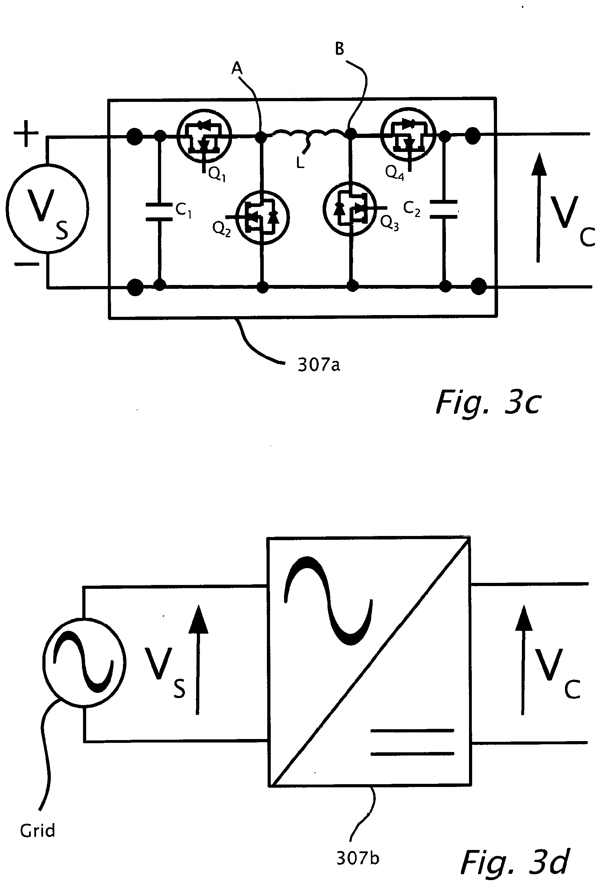

Reference is now made to Fig. 3c which shows more details of voltage-compensation circuit 307 shown in Figures 3a and 3b, which are not part of the invention. Voltage-compensation circuit 307 may be implemented using a direct current (DC) to DC converter 307a. DC-to-DC converter 307a may be a buck circuit, a boost circuit, a buck + boost circuit or switched-mode power supply (SMPS). The output of DC-to-DC converter 307 is connected in series within string 315 to add compensation voltage (Vc) to string 315. The DC source voltage input (Vs) to DC-to DC converter 307 may be provided from the combined DC output of strings 315, or strings 109. Alternatively, DC source voltage input (Vs) may be provided by a micro-inverter converting AC from the mains grid or another independent source of DC power such as a battery or DC generator. Circuit 307 as shown in Fig. 3c, is a conventional buck-boost DC- to-DC converter circuit which has an input voltage Vs with an input capacitor $C_1$ connected in parallel across Vs. Two switches may be implemented as field effect transistors (FET) with integral diodes: a high side buck switch $Q_1$ and a low side buck switch $Q_2$ connected in series by connecting the source of $Q_1$ to the drain of $Q_2$. The drain of $Q_1$ and the source of $Q_2$ may be connected parallel across the input capacitor $C_1$. A node A is formed between switches $Q_1$ and $Q_2$ to which one end of an inductor L is connected. The other end of inductor L is connected to the boost circuit of buck-boost DC-to-DC converter 307 at a node B. Node B connects two switches implemented as field effect transistors (FET): a high side boost switch $Q_4$ and a low side boost switch $Q_3$ together in series where the source of $Q_4$ connects to the drain of $Q_3$ to form node B. The drain of $Q_4$ and the source of $Q_3$ connect across an output capacitor $C_2$ to produce the output voltage $V_C$ of buck-boost DC-to-DC converter 307.

Reference is now made to Fig. 3d which shows an implementation of circuit 307 shown in Figures 3a and 3b, which is not part of the invention. Voltage compensation circuit 307 may be implemented using an alternating current (AC) to DC inverter. The AC to DC inverter 307b may be a type of switched mode power supply (SMPS). When voltage-compensation circuit 307 is an AC to DC converter 307b, the DC output of the AC to DC converter is connected in series within a string 315. The AC input (Vs) to the AC to DC converter may be provided from the mains grid, from the AC output of inverter 103 or by another independent source of AC power.

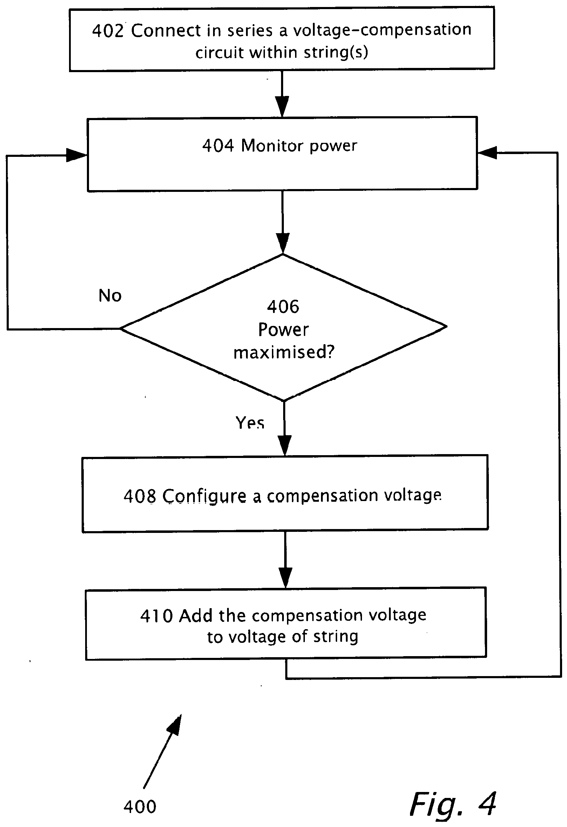

Reference is now made to Fig. 4 which shows a method 400 which may be applied to power harvesting system 30b shown in Fig. 3b, according to a feature of the present invention. In step 402, an output voltage (Vc) of circuit 307 is wired in series with a series-connection of panels 101 to form compensated string 315. The input voltage (Vs) to circuit 307 may be from direct current (DC) output 211, the alternating current (AC) output of inverter 103 or a separate independent AC or DC electric supply. Several compensated strings 315 outputs may then be connected in parallel and further connected to the input of an inverter 103 as shown in Fig. 3b.

In step 404, a circuit parameter of each parallel connected string 315 is monitored in the case of system 30b. The circuit parameter may be the current flowing in a string 315, the voltage across a string 315, the voltage of a photovoltaic string 109 and/or the voltage (Vc) across a circuit 307. The current and voltages in a string 315 may be used to determine the power (P) in a string 315 or a photovoltaic string 109 by virtue of power being equal to voltage (V) multiplied by current (I).

In decision block 406, a control algorithm stored in a circuit 307 adjusts compensation voltage $V_C$ to maximize output power of string 315. In step 408, a compensation voltage $V_C$ for strings 315 is configured based on the result of the control algorithm performed in steps 404 and 406. The compensation voltage $V_C$ for strings 315 in step 408 may be a positive or a negative voltage polarity with respect to the voltage polarity of a string 109. In step 410, the compensation voltage $V_C$ is added to string 315. In the case of the positive voltage for $V_C$, the voltage of a string 315 may be increased in step 408. In the case of the negative voltage for $V_C$, the voltage of string 315 may be decreased in step 408.

Reference is still being made to Fig. 4. Method 400 may also be applied to system 30a (Fig. 3a) which uses central controller 313. In the case of system 30a, in step 404 central controller monitors or calculates a net total power from system 30a. The net total power from system 30a is equal to the power produced by strings 109 subtracted from the power added by compensation circuits 307.

When the voltage (Vs) and hence power to the input of circuit 307 is derived from DC bus 211 or the output of inverter 103 to give compensated voltage (Vc). The net total power from system 30a may be derived directly by monitoring (step 404) power on DC bus 211.

When the voltage (Vs) and hence power to the input of circuit 307 is derived from an independent DC source or AC source such as a mains supply to give compensated voltage (Vc). The net total power from system 30a may be derived by subtracting power monitored on DC Bus 211 (step 404) from the power added by compensation circuits 307.

In decision block 406, compensation voltages $V_C$ of all strings 315 may be adjusted to maximize the net total power from system 30a. In step 408, a compensation voltage $V_C$ for a string 315 is configured based on the result of the control algorithm performed in steps 404 and 406. In step 410, the compensation voltage $V_C$ is added to a string 315.

During a sustained use of systems 30a or 30b over a period of time, the number and type of serial connected panels 101 in a string 315 may change, some panels may become faulty and/or operate in a current bypass mode or panels may be replaced with ones that have different electrical characteristics. Under these circumstances, the control algorithm maintains strings 315 at their maximum power point (MPP) by adding compensation voltage to each string 315 to maintain maximum power from each string 315. When all strings 109 are found to be operating at maximum power output level and maximum power point, no voltage compensation $V_C$ may be required and voltage compensation $V_C$ added to string 315 is at or near zero volts.

With respect to both systems 30a and 30b. In each iteration of the control algorithm performed in steps 404 and 406, it may be possible to subtract from all the compensation voltages ($V_c$) in each string 315, the minimum compensation voltage $V_c$. Subtracting the minimum compensation voltage $V_c$, may prevent a drift in the compensation voltages ($V_c$) going too high for no reason. Alternatively, it may be possible to tie the compensation voltages ($V_c$) to a level that will optimize the overall voltage of strings 315 to be optimal for the input of inverter 103, thereby increasing the conversion efficiency of inverter 103.

The present features with respect to method 400 and systems 30a or 30b, may be compared to conventional system 20 (Fig. 2) by way of the same numerical example, where three compensated strings 315 are used. It may be assumed just for the purpose of the numerical example that the three compensated strings 315 are compensated by circuit 307 which may be an AC to DC converter powered from the grid. Therefore, circuit 307 receives and converts voltage (Vs) and hence power from the electrical grid. If two strings 109 are equally irradiated such that each string operates with a string 109 voltage of 600 volts and string current of 10 amperes, each of the two strings generates (10 amperes · 600 volts) 6 kilowatts. If one under-performing string 109 is partially shaded or if a panel 101 is removed or bypassed, there may be a string voltage of 550 Volts and current of 10 amperes, which means (10 amperes · 550 volts) 5.5 kilowatts may be generated by the under-performing string 109. The maximum power 5.5 kilowatts may be generated by the under-performing string 109 only if the under-performing string 109 can be operated at maximum power point (MPP).

Voltage-compensation circuit 307 of the under-performing string 109 may be configured (step 408) by controller 313 to add 50 volts (Vc) in series with under-performing string 109 while maintaining the current of 10 amperes (step 410). Adding 50 volts by use of voltage-compensation circuit 307, maintains string 315 voltage at 600 volts also for under-performing string 109. Increasing the voltage of the string 315, allows the one under-performing string 109 to operate at MPP and also requires an extra (10 amperes · 50 volts) 500 Watts when compared to the 6 kilowatts in each of the other two strings 315. The overall power output of system 30a or 30b is 18 kilowatts, from two strings 109 providing 12 kilowatts (2 · 6 kilowatts), the under-performing compensated string 109 providing 5.5 kilowatts and the grid providing 500 watts (50 volts · 10 amperes) via circuit 307. The power provided from the 3 strings 315 may be therefore, the same as system 20 at 17.5 kilowatts (2 · 6 kilowatts + 5.5 kilowatts).

The benefit of systems 30 compared with system 20 is that 500W-1 kW switching converters 307 may be required compared with 6-10kW switching converters used in system 20. The difference in power rating may represent a huge improvement in cost and reliability of systems 30 compared with system 20.

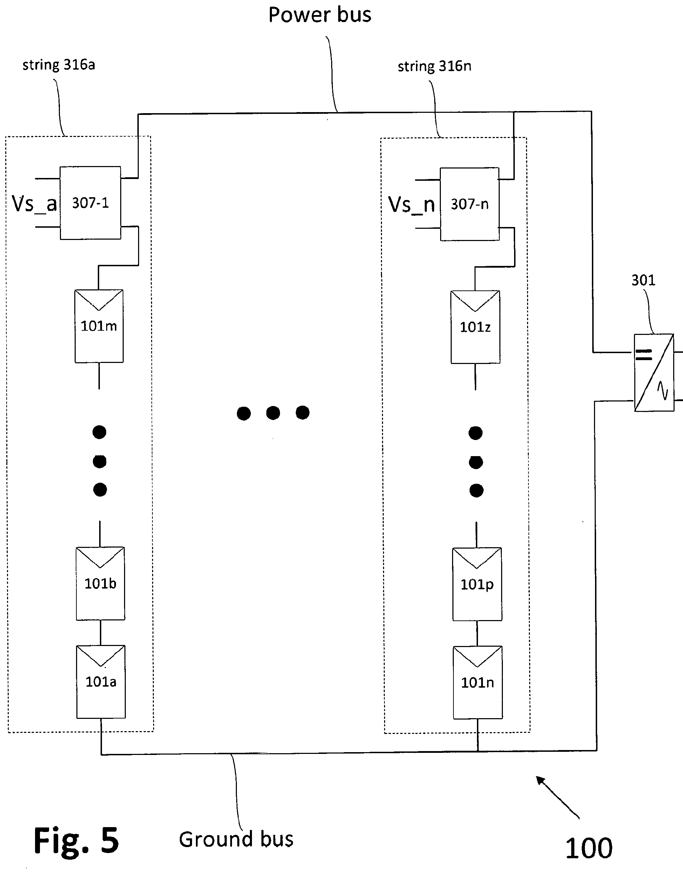

Referring still to Fig. 4, the method 400 and/or one or more steps set forth in the method 400 may be performed by and/or for any of the systems devices, and/or components discussed herein, such as described in relation to Figs. 1-3 and to Figs. 5-16, which are described below in greater detail.

Reference is now made to Fig. 5, which depicts a photovoltaic installation according to exemplary embodiments. Optimized photovoltaic power system 100 may be variously configured. In one embodiment, the photovoltaic power system comprises a plurality of parallel-connected photovoltaic strings 316 (e.g. 316a, 316n etc.). A photovoltaic string 316 includes a plurality of series-connected photovoltaic panels 101 (e.g. solar cells, solar panels), which may be referred to as photovoltaic (PV) modules 101. According to some aspects not covered by the present invention, other types of power sources may be used, such as batteries, storage devices, power producing device, and the like. According to some aspects, a string 316 may be or may be similar to the string 315. According to some embodiments, due to the strings having different locations, each string (and the modules within a string) may receive a different amount of sunlight, which may cause one string to produce a different amount of power from another string. Furthermore, the serial connection between the modules within each string may lead to each string having a different voltage between the two ends of the string.

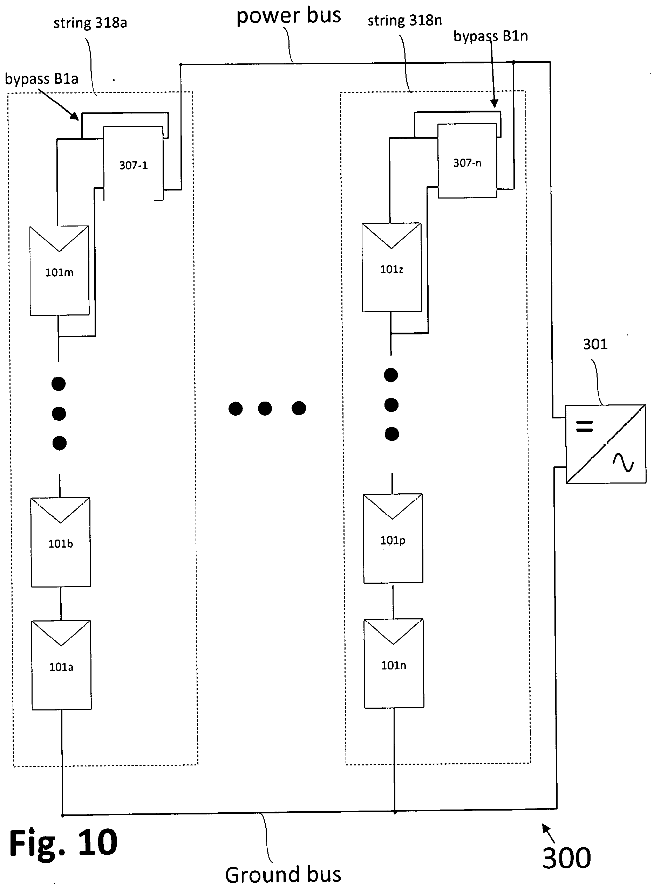

For different strings to be coupled in parallel, one or more or all of the strings in system 100 are coupled to a string compensation circuit, configured to adapt the string voltage to allow parallel coupling. The input of a compensation circuit 307 (e.g. 307-1, 307-n etc.), sometimes referred to herein as a compensation device 307 or compensator 307, is coupled to an external power source Vs (e.g. Vs_a, Vs_b etc.). In the invention, the external power source will be detailed with reference to Fig.10. In other examples, which are not part of the invention, the external power source may be implemented in various ways. For example, the external power source may be an alternating-current (AC) source or a direct-current (DC) source. In other examples, which are not part of the invention, power source Vs may supply power produced by one or more PV modules in system 100.

Compensator 307 may be configured in various ways. In an example not covered by the invention, if power source Vs outputs AC voltage, compensator 307 may include an AC-to-DC converter. In another example, if power source Vs outputs DC voltage, compensator 307 may include a DC-to-DC converter. In some embodiments, which are not according to the invention, compensator 307 may output a positive voltage, allowing the strings comprising system 100 to feature a common voltage equal to or higher than the highest string voltage without use of compensator units. According to the invention, compensator 307 includes a polarity adjustment circuit, configured to output a DC voltage of either positive or negative polarity, which allows system 100 to feature a common string voltage of arbitrary magnitude. In this manner, each string 316 may be configured to operate at a voltage level optimal for generating maximum power, with one or more compensators 307 (e.g. 307-1, 307-n) configured to adjust the voltage between the ground bus (or other bus not necessarily at ground) and the DC bus to a uniform value for one or more or all strings in the power system. For example, in string 316a, the combined voltage of the photovoltaic modules comprising the string (101a, 101b... 101m) may be configured to maximize the power output by the modules, with compensator 307-1 increasing or decreasing the total string voltage to match the system common voltage level. Compensator 307 may output a voltage configured to bring the total voltage between the ground and power buses to a desirable operating point, and compensator 307 may output a current which is equal to the string current at the desirable operating point. In some embodiments, the power processed by each compensation circuit may be small compared to the power produced by each string, which may result in a cheap and efficient method of producing maximum power by allowing a string to operate at the string's optimal voltage without requiring electronics rated to process the full-string power. A ground bus (or other bus not necessarily at ground) and DC bus may be coupled to the ends of each PV string, and the ground bus (or other bus not necessarily at ground) and DC bus may be input to inverter 301 or some other device (e.g., storage device, DC/DC power converter, etc.), which may be configured to output AC power to a load, such as a grid, a home, or energy storage devices.

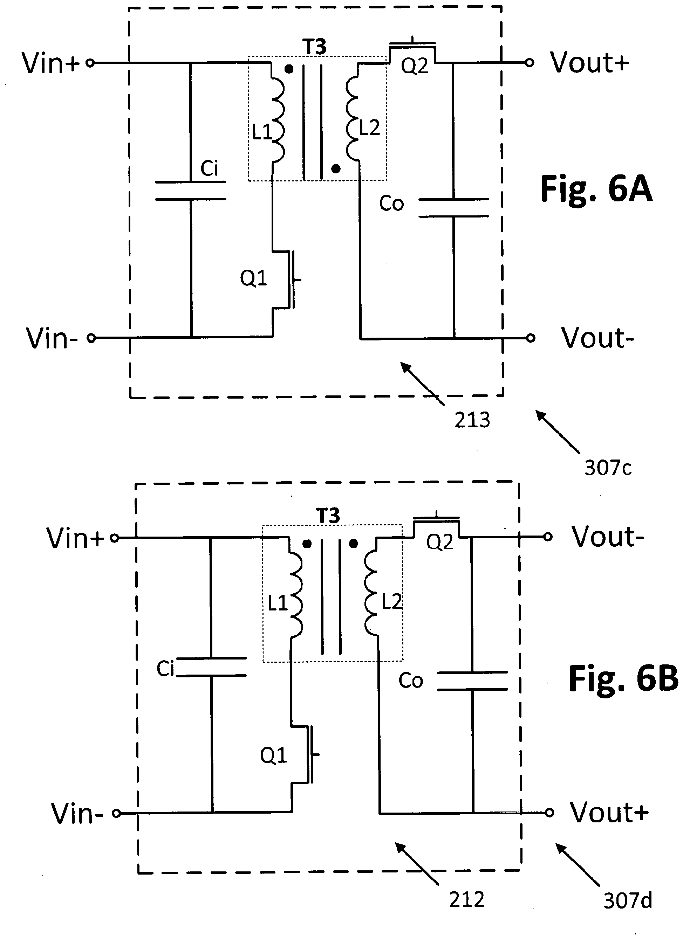

Reference is now made to Fig. 6A, which shows one exemplary implementation of a string compensation circuit/device 307c, according to some embodiments. A compensation device 307 includes an isolated power converter, such as a Flyback DC-DC converter or a Forward DC/DC converter. For the purpose of this example, a Flyback converter is considered and described, while other types of isolated converters may be used in exemplary embodiments. Flyback converter 213 may feature positive and negative input terminals (Vin+ and Vin-, respectively), and positive and negative output terminals (Vout+ and Vout-, respectively). The inputs may be electrically isolated from the outputs by use of transformer T3 formed by magnetically coupling windings L1 and L2. For this reason, a Flyback converter can be considered an "isolated converter", i.e. a converter in which the input terminals are electrically isolated from the output terminals. The polarity of the Flyback output voltage may be configured by the polarity of winding L2. If L1 and L2 are wound with the same polarity, the voltage output by the converter will be inverted (i.e. of opposite polarity than the input voltage). If the polarity of winding L1 and the polarity of the winding L2 are different, the output voltage will be non-inverted (i.e. of the same polarity as the input). In converter 213, the windings L1 and L2 have opposite polarities, so converter 213 might not be inverting. Switches Q1 and Q2 (e.g. MOSFETs, etc.) may be switched in a complementary manner (i.e. when Q1 is ON, Q2 is OFF, and vice-versa), and may be used to regulate the output DC voltage. In some embodiments, switch Q2 may be replaced by a diode. The magnitude of the output voltage may depend on the windings ratio between windings L1 and L2, and on the duty cycle of switch Q1. The output voltage magnitude may be higher or lower than the input voltage magnitude. The switching may be controlled by a control unit such as a microprocessor, ASIC, FPGA or similar suitable control device (not explicitly depicted). Capacitors Ci and Co may stabilize the input and output voltages, respectively. Use of an isolated converter may be advantageous because the output voltage may be "floating" with regard to the input voltage, and by coupling the outputs serially with a photovoltaic string, the string voltage can be modified by the converter output without regard for the relative voltage input to the compensation circuit.

Reference is now made to Fig. 6B, which shows an exemplary implementation of a string compensation circuit 307d/string compensation device 307d, according to some embodiments. A compensation circuit 307 may include an inverting Flyback converter, such as converter 212. Converter 212 may include the same functional components as those shown in converter 213, operating in the same way, with the difference between converter 213 and 212 being in the polarity of the windings. In converter 212, windings L1 and L2 are of the same polarity, resulting in a reversal of the polarity of the output voltage; the "upper" output terminal is the negative terminal Vout-, and the "lower" output terminal is the positive terminal Vout+.

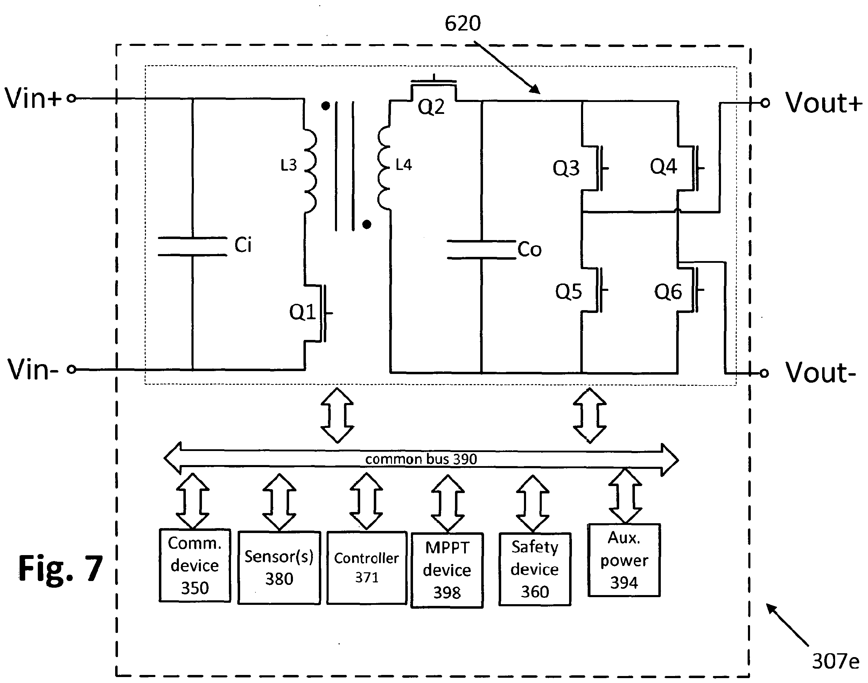

Reference is now made to Fig. 7, which depicts one example of a compensation circuit 307, which is shown as bipolar compensation circuit 307e, according to an exemplary embodiment. While various examples of compensation circuits 307 may be described and/or referred to herein with respect to a figure or embodiment, any disclosed compensation circuit 307 may be implemented in any disclosed or described example or embodiment. Bipolar compensator 307e includes an isolated DC/DC converter 620 such as the Flyback converter discussed herein. The bipolar compensator further includes a polarity adjustment circuit such as a plurality of switches Q3, Q4, Q5, Q6 configured in a "full-bridge" topology, and coupled in parallel with the DC/DC converter 620 output. When Q3 and Q6 are ON and Q4, Q5 are OFF, the compensator output voltage may have the magnitude of the DC/DC converter output stage, with the opposite polarity. Switches Q3, Q4, Q5 and Q6 may be controlled by the same controller that controls switches Q1 and Q2, or by a different controller. By enabling a positive or negative output DC voltage, any common DC string voltage may be applied to a plurality of parallel-coupled photovoltaic strings. A bipolar compensation unit can increase a string voltage by outputting a positive DC voltage, or can decrease the string voltage by outputting a negative DC voltage. Compensation circuit 307e may be coupled to communication devices configured to communicate with one another and/or one or more system management units, such as a master system control device. Communication with other compensators and/or system management units may be useful in some embodiments to synchronize a common string voltage. In some embodiments synchronization might not be necessary, such as where, for example, a common voltage is imposed by an external device or system. In some embodiments, compensator 307e may include Maximum Power Point Tracking (MPPT) device 398, which may be configured to extract maximum power from a PV module that may be coupled to the power device. In some embodiments, the DC/DC conversion controller may include MPPT functionality. Compensator 307e may further comprise control device 371, which may be a microprocessor, Digital Signal Processor (DSP), ASIC and/or an FPGA. Control device 371 may control and/or communicate with other elements of compensator 307e over common bus 390 (or one or more other bus components). In some embodiments, compensator 307e may include circuitry and/or sensors 380 configured to measure parameters on or near a photovoltaic module and/or compensator components. These parameters may include the voltage and/or current output by the module, the power output by the module, the irradiance received by the module, and/or the temperature on or near the module. In some embodiments, compensator 307e may include communication device 350, which may be configured to transmit and/or receive data and/or commands from other devices. Communication device 350 may communicate using Power Line Communication (PLC) technology, or wireless technologies such as ZigBee, Wi-Fi, Bluetooth, cellular communication or other wireless methods. In some embodiments, compensator 307e may include safety devices 360 (e.g., fuses, circuit breakers, and/or Residual Current Detectors). Compensator 307e may further include an auxiliary power circuit 394, which may be configured to supply various voltage and/or current levels to power the various compensator components. The various components of compensator 307e may communicate and/or share data over common bus 390 (or one or more other bus components).

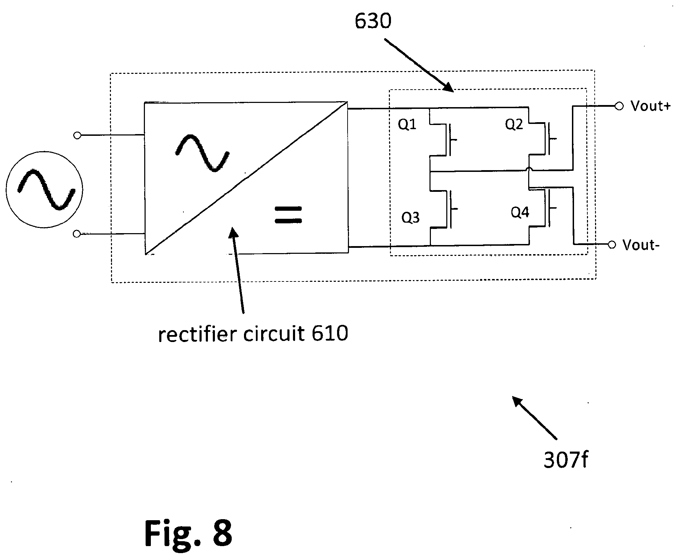

Reference is now made to Fig. 8, which depicts a bipolar compensation circuit 307f, which is not according to the invention. Bipolar compensator 307f may include a rectifier circuit 610 coupled (e.g., in parallel) to a polarity adjustment circuit 630. The polarity adjustment circuit 630 may be composed of switches Q1, Q2, Q3 and Q4 configured in a "full-bridge" arrangement. Rectifier circuit 610 may be configured to convert an AC input to a DC output, and may be implemented using, for example, four diodes in a "rectifying full bridge" arrangement. Bipolar compensator 307f may receive an AC output from an external power source (e.g., from the power grid or from a DC/AC inverter). Rectifier circuit 610 may further include a DC/DC conversion stage, and may be controlled to output a DC voltage of any magnitude. Switches Q1, Q2, Q3, and Q4 may be configured to control to polarity of the output DC voltage. When Q1 and Q4 are ON and Q2, Q3 are OFF, the compensator DC output may be positive, and when Q1 and Q4 are OFF and Q2, Q3 are ON, the compensator DC output may be negative. Compensator 307f may include communication, safety, sensor, MPPT and/or auxiliary power devices similar to the circuits discussed with regard to compensator 307e, but not explicitly depicted in Fig. 8 for the sake of brevity.

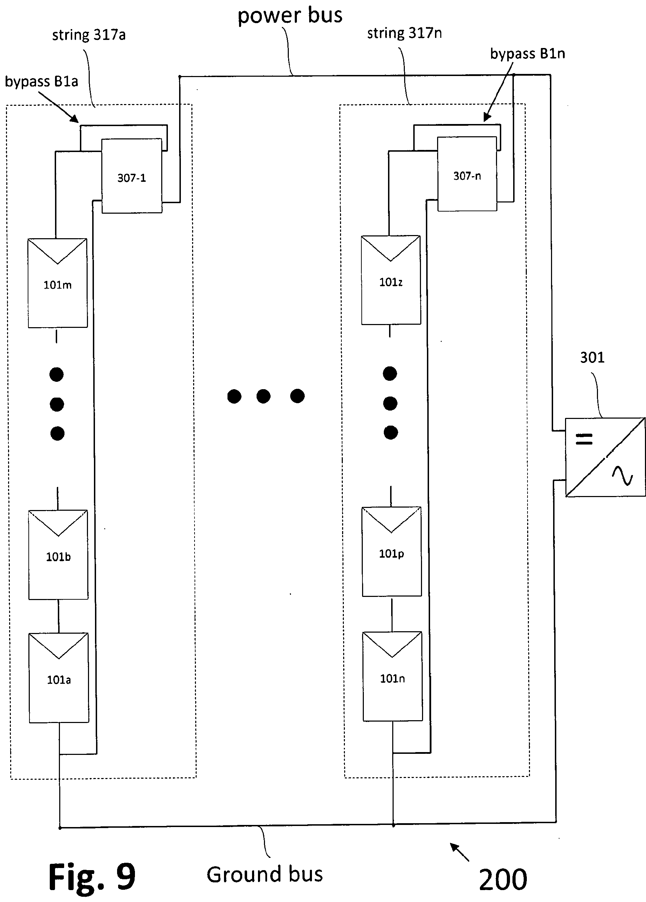

Reference is now made to Fig. 9, which depicts a photovoltaic installation , which are not according to the invention. . Optimized photovoltaic power system 200 may be variously configured. In one embodiment, the photovoltaic power system may comprise a plurality of parallel-connected photovoltaic strings 317 (e.g. 317a, 317n etc.). A photovoltaic string 317 may include a plurality of series-connected photovoltaic modules 101 (e.g. solar cells, solar panels). According to some aspects, a string 317 may be or may be similar to the string 315. The parallel string may be coupled between a ground bus (or other bus not necessarily at ground) and a DC bus, with the input of each bus connected to inverter 301, which may be configured to output AC power to the grid, home, or energy storage devices. Due to the strings 317 having different locations, each string 317 (and the modules within a string 317) may receive a different amount of sunlight and produce a different amount of power. Furthermore, the serial connection between the modules within each string 317 may lead to each string having a different voltage between its two ends. For different strings to be coupled in parallel, one or more or all of the strings in system 200 may be coupled to a string compensation circuit, which may be configured to adapt the string voltage to allow parallel coupling. A compensation circuit 307 (e.g. 307-1, 307-n etc.) may receive a DC input from one or more PV modules comprising a PV string. As shown in Fig. 9, each compensator 307 may be coupled to an entire PV string. For example, the negative input (Vin-) of compensator 307-1 may be coupled to the ground bus (or other bus not necessarily at ground), and the positive input (Vin+) may be coupled to the positive output terminal of PV module 101m, which may be the last module in the serially connected string of modules 101a..101m. Compensator 307 may include an isolated DC/DC converter such as one of the Flyback converters depicted in Figs. 6A and 6B. By connecting the positive compensator input Vin+ to one of the outputs via bypass B1a, two current paths between the compensator input terminal (s) and output terminal(s) may be formed. For example, current may be able to flow from the compensator input directly to the output via bypass B1a, and current may flow into the compensator at the input terminals, and flow out of the compensator at the outputs after being processed by the compensator. By dividing the string current into multiple portions, the power injected into the inputs of the compensator 307-1 may be significantly reduced, and the cost of implementing may be reduced as well. For instance, if a large voltage (e.g. a full-string voltage) is input to a compensator 307, by directing a small portion of the current to the compensator inputs and a larger portion directly to the output (via a bypass path), the compensator may process a reduced amount of power, and the components needed for realization of the compensator may be correspondingly smaller and cheaper.

Reference is now made to Fig. 10, which depicts a photovoltaic installation according to the invention Optimized photovoltaic power system 300 comprises a plurality of photovoltaic strings 318 (e.g. 318a, 318n etc.) coupled in parallel between ground and DC buses. A ground bus (or other bus not necessarily at ground) and DC bus are coupled to the ends of each PV string 318, and the ground bus (or other bus not necessarily at ground) and DC bus may be input to inverter 301, which may be configured to output AC power to a load, such as a grid, a home, and/or energy storage devices. The strings 318 feature a plurality of serially-connected photovoltaic modules 101 (e.g. 101a, 101b etc.) and a string compensation circuit 307 (e.g. compensator 307-1, 307-n etc.). According to some aspects, a string 318 may be or may be similar to the string 315. The two inputs of a string compensation circuit 307 (e.g. 307-1) are coupled in parallel to a photovoltaic module (e.g. 101m), and a portion of the power produced by PV module may be input to the compensator 307. The rest of the power is transferred directly to the compensator 307 output via a bypass path. The compensation circuit 307 may process the input power and output a voltage to bring to the total string voltage to the desired common voltage between the ground and power buses, while allowing the plurality of series-connected PV modules in the string to operate at a voltage yielding maximum power output. Similarly to other embodiments disclosed herein, processing a portion of the string power may allow components to be smaller and cheaper, and may result in enhanced system efficiency.

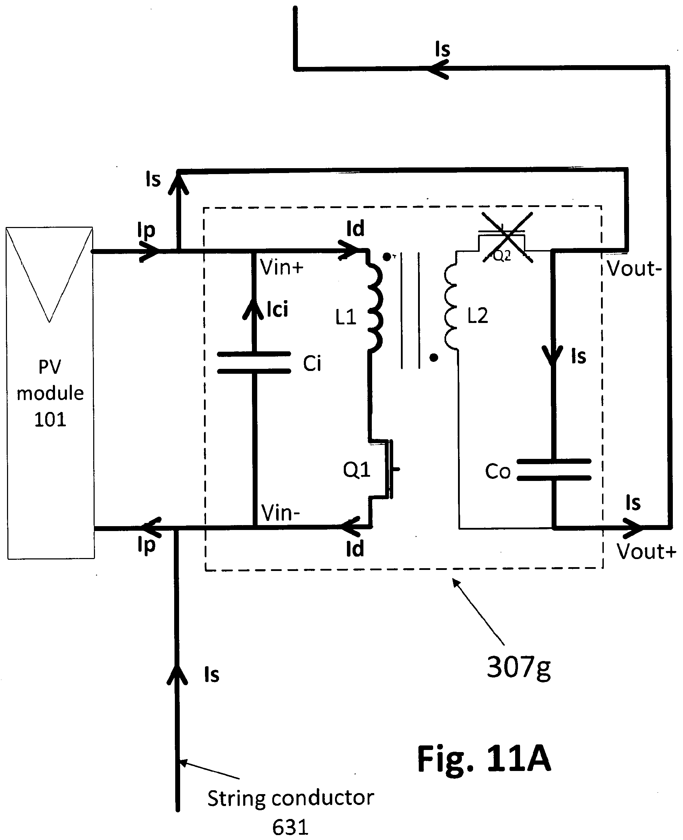

Reference is now made to Fig. 11A, which illustrates the current flowing in different branches of a photovoltaic module 101 coupled to a compensator 307g according to exemplary embodiments. According to some aspects, the module 101 may be part of a string of panels 101, such as shown in other figures discussed herein. In the illustrative exemplary embodiment depicted in Fig. 11A, a unipolar compensator (e.g., might not include a polarity adjustment circuit) featuring a non-inverting Flyback converter is used. The current-flow analysis is similar for a bipolar compensator such as compensator 307e, and either a unipolar compensator or a bipolar compensator may be used in exemplary systems and scenarios, such as the systems and scenarios described herein. Unipolar compensator 307g may include a Flyback converter featuring a pair of input terminals, Vin+ and Vin-, and a pair of output terminals, Vout+ and Vout-. For brevity's sake, additional components that may be featured in the compensator (e.g. communication, safety, control and/or monitoring devices etc. as depicted with regard to compensator 307e) are not explicitly depicted.

The compensator may include capacitor Ci coupled between the inputs, and capacitor Co coupled between the outputs. Switches Q1 and Q2 (e.g. MOSFETs) may be switched in a complementary manner. Q1 may be coupled between the negative input terminal Vin- and winding L1, while Q2 may be coupled between the negative output terminal Vout- and winding L2. The windings may be magnetically coupled to one another by a magnetic core. PV module 101 may be coupled to the inputs, and may input photovoltaic power to the compensation circuit. When Q1 is ON and Q2 is OFF (illustrated in Fig. 11A with an "X"), winding L1 may draw current from PV module 101 and the discharging capacitor Ci. The module current Ip may be divided into current portion Id which may be input to the compensator may charge L1, and into current portion Is which may bypass the compensator input and may flow through the output terminals, charging capacitor Co while flowing from Vout-to Vout+. Current Is may be the effective string (e.g., string 317a depicted in Fig. 9) current, and may flow into compensation circuit 307g via string conductor 631, and may continue to flow from Vout+ via string conductor 631. The power drawn by compensator 307g during this time is given by $V_{ci} \cdot (I_p - I_s)$, which may be significantly lower than the power output by module 101, which is given by $V_{ci} \cdot I_p$. Since Vout- is coupled to Vin+, the output voltage is given by $V_{out+} = V_{in+} + V_{C_o}$. In other words, if $V_{C_o}$ is positive, the output voltage may be higher than the input voltage. If an inverting Flyback is used, the output voltage may be $V_{out+} = V_{in+} - V_{C_o}$, and the output voltage will be lower than the input voltage.

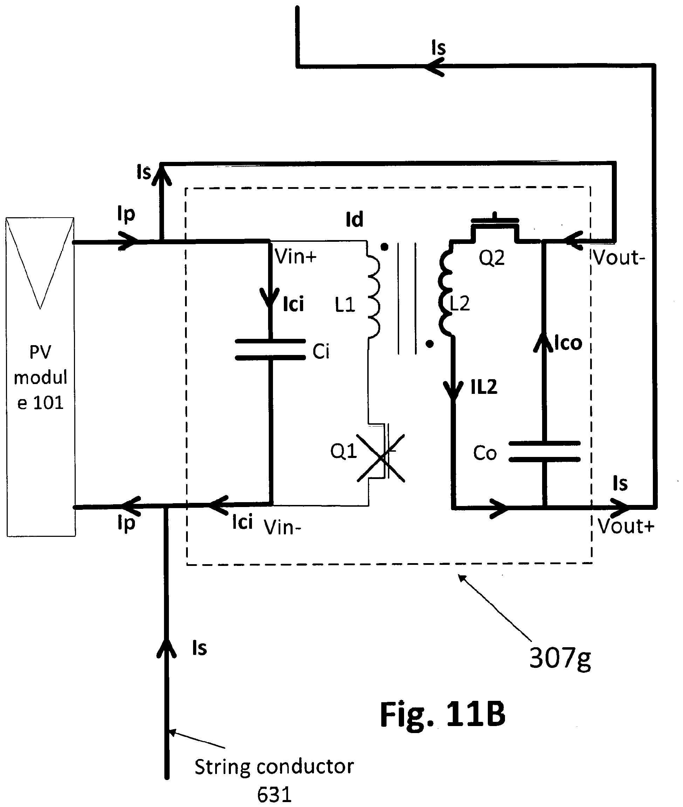

Reference is now made to Fig. 11B, which illustrates the current flowing in different branches of a compensator 307g when Q1 is OFF (illustrated in Fig. 11B with an "X") and Q2 is ON. Photovoltaic module 101 may output a current Ip, which is divided into two portions. One portion, Is, bypasses the compensator inputs and flows directly to the negative output terminal Vout- via a bypass path. A second portion, Ici flows into the compensator to charge capacitor Ci. Winding L1 transfers stored energy via a shared magnetic core to winding L2, which discharges the energy by generating current IL2 which flows towards output Vout+. Capacitor Co discharges, adding the capacitor Co's discharge current Ico to IL2 form the string current Is. Similarly to when Q1 is ON and Q2 is OFF, the power input to compensator 307g may be significantly lower than the power generated by the panel. By using a suitable windings ratio for L1 and L2 and operating switches Q1 and Q2 at an appropriate duty cycle, the charging and discharging of capacitors Ci and Co may be configured to adjust output voltage Vout+ to a value which brings a photovoltaic string voltage to a desired common voltage. For example, if L1 contains n1 windings and L2 contains n2 windings, the output voltage Vout+ can be calculated as:

$$V_{out+} = V_{in+} + (V_{in+} - V_{in-}) \cdot \frac{n_2}{n1} \cdot \frac{D}{1-D}$$

where D is the duty cycle of switch Q1 and (1-D) is the duty cycle of switch Q2. If an inverting Flyback is used, the output voltage Vout+ can be calculated as: $V_{out+} = V_{in+} - (V_{in+} - V_{in-}) \cdot \frac{n_2}{n1} \cdot \frac{D}{1-D}$. If the compensator includes a polarity adjustment circuit (e.g., a full-bridge of switches), either output value may be obtained, according to how the polarity adjustment circuit is operated. Appropriate choice of windings ratio and duty-cycle may allow flexible and robust system management, while obtaining high efficiency and low-cost by the compensator processing a portion of the string or PV module output power.

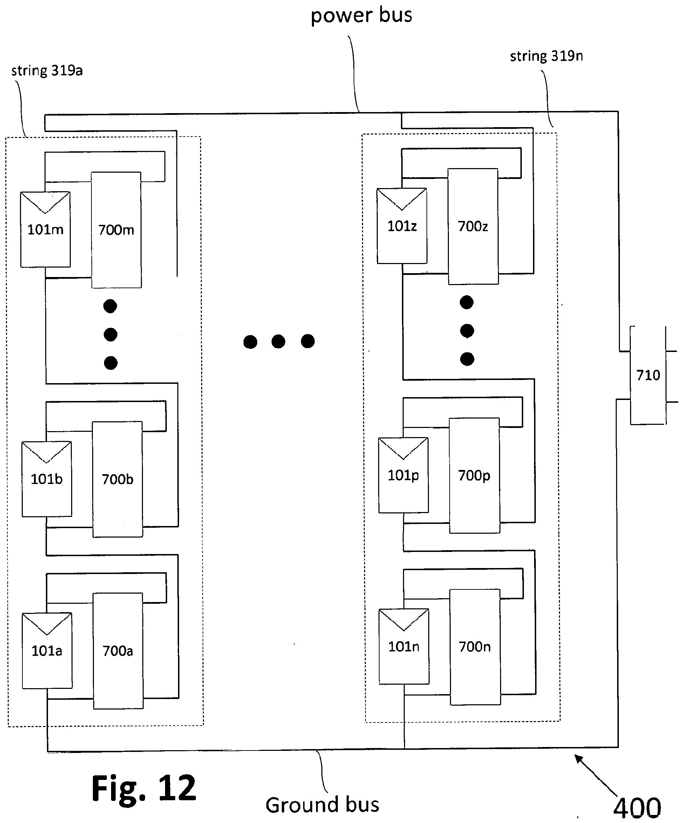

Reference is now made to Fig. 12, which shows an additional example, which is not according to the invention. Photovoltaic power system 400 may comprise a plurality of photovoltaic strings 319 (e.g. 319a, 319n etc.) coupled in parallel between a ground bus (or other bus not necessarily at ground) and a power bus. A photovoltaic string 319 may include a plurality of photovoltaic modules 101 (e.g. 101a, 101b, etc.) such as solar cells and/or solar panels. According to some aspects, a string 319 may be or may be similar to the string 315. A plurality of power devices 700 (e.g. 700a, 700b, etc.) may be coupled to modules 101 such that each power device 700 may be coupled to one or more modules. A power device 700 may be the compensation circuit 307 discussed herein, may be similar to the compensation circuit 307 discussed herein, and/or may include one or more or all of the compensation circuit 307's components. For example, the power device 700 may be similar to unipolar compensation circuit 307g or to bipolar compensation circuit 307e, featuring a Flyback DC/DC converter. In some embodiments, a DC/AC microinverter may be utilized to output an AC voltage, with each microinverter's output coupled in series to generate an AC string voltage of comparable magnitude to grid voltage. In exemplary system 400, the inputs of each power device may be coupled to the outputs of a PV module 101. In some embodiments, multiple modules may be coupled in series and the resultant series coupled to an input of a power device 700. In some embodiments, power devices may be coupled to some or to all of the modules in a string or a system.

Each power device 700 may comprise a power conversion circuit configured to regulate the power drawn from its corresponding PV modules(s), by using techniques such as MPPT, "perturb and observe", impedance matching, and/or other methods of determining and tracking a maximum power point or a power point close to the maximum power point. The positive input terminal of one or more power device(s) 700 may be coupled to one of the output terminals, allowing current to flow directly to the device output without being processed by the power device, which may potentially result in efficiency advantages as explained herein. For example, if each module 101 in the system is coupled to a power device 700, the majority of each string's current may flow directly from power device inputs to the output with being processed by the device. The device 700 may still process a small portion of the system power, employing power conversion to ensure that each module is working near or at its maximum power point. Each power device 700 may receive a DC power input, and output an appropriate output. In some embodiments, the output may be a DC voltage. Depending on the particular power device used and the control applied to the device, a DC signal greater or smaller than the input voltage may be obtained. In some embodiments (e.g. if power device 700 includes a polarity adjustment circuit allowing the power device 700 to function as a microinverter), each power device 700 may be configured to output an AC signal. In some embodiments, each power device 700 may output a time-varying DC signal such as a rectified sine wave, rectangular, or square wave. Each power device 700 may have one output coupled to the device 700's positive input terminal, and the device 700's other output coupled in series to the photovoltaic string A system power device 710 may be coupled between the ground and power buses. In one example, when one or more power devices 700 output DC power, system power device 710 may include or be an inverter configured to convert a DC input (e.g., input from the one or more power devices 700) to an AC output to a load, such as a home or a grid. In one example, the system power device 710 may be a storage device, such as a battery or capacitor. In one example, the system power device 710 may be a DC/DC converter. In some embodiments, device 710 may include safety, control, communication, monitoring and/or management devices, which may be coupled to one or more of the other components of system 400, such as a power device 700.

While Fig. 12 may depict a system of serially connected PV devices power 700, embodiments may include other connection methods. For example, in some embodiments, a plurality of PV power devices may be coupled in parallel. According to some aspects, this configuration may be functionally and/or electrically equivalent to a system such as system 400, wherein each string is of length one (i.e., each string contains one PV module coupled in parallel to one PV power device, with the power device inputs and outputs configured as in system 400). Some embodiments may be of hybrid serial-parallel nature. For example, an exemplary photovoltaic string may include a plurality of pairs of PV modules, wherein each module in each pair is coupled to a power device in the manner disclosed herein (e.g., each power device may include an isolated converter with one of the converter's inputs coupled to one of the converter's outputs) the power devices are coupled in parallel, and a plurality of such pairs are coupled in series, forming a serial string coupled between the ground and power buses. In some embodiments, additional power sources may be featured, such as batteries, wind turbines, fuel cells, etc. Many additional layouts, which make use of the novel features disclosed herein, may be implemented and are included in one or more exemplary embodiments.

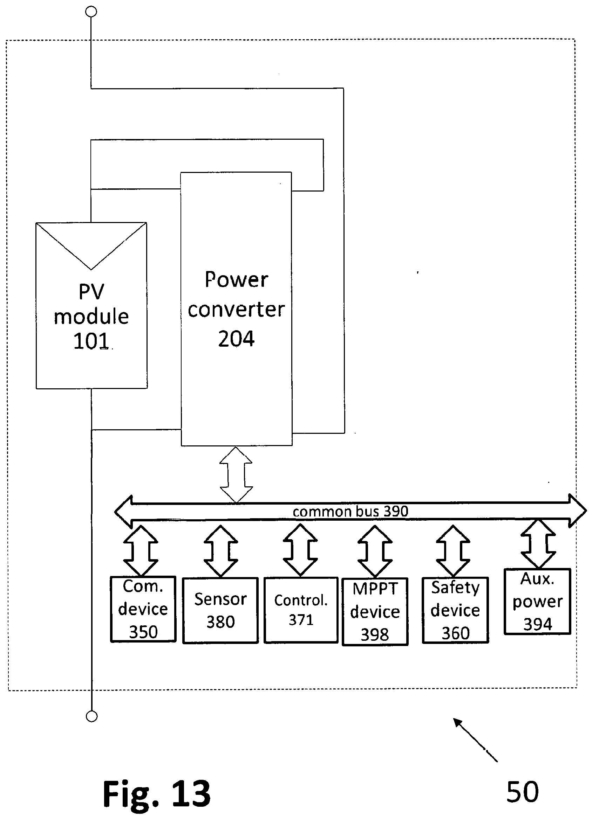

Reference is now made to Fig. 13, which illustrates an integrated block 50, which may be part of a PV system, according to exemplary embodiments. Integrated block 50 may include PV module 101, which may be coupled to power converter 204. In some embodiments, the converter 204 may be and/or include one or more components or devices described herein. For example, the converter 204 may be a DC/DC or DC/AC converter, configured to receive a DC input from module 101 and output a DC, time-varying-DC, or AC signal. Power converter 204 may include an isolated converter such as a Flyback or Forward converter (such as described herein), and in some embodiments may include a polarity adjustment circuit (such as described herein). Integrated block 50 may include circuits and devices discussed herein (e.g. bipolar compensator 307e), such as communication device 350, sensor(s) 380, controller 371, MPPT device 398, safety device(s) 360, auxiliary power circuit 394, and/or common bus 390 (or one or more other bus components). Integrated block 50 may be packaged and deployed as a single unit. In some embodiments, a single integrated block 50 may be deployed in one or more of the PV strings to supply voltage-compensation functionality. In some embodiments, entire PV strings may comprise serially coupled integrated blocks. In some embodiments, integrated block 50 may feature a few terminals (e.g., two terminals), which may allow for fast and simple system installation, while obtaining the benefits of a sophisticated electronic system with minimal installation complexity. In some embodiments, integrated block 50 may be embedded onto a roof shingle, with electrical contacts placed to create serial electric connection between integrated blocks when shingles are placed next to one another.

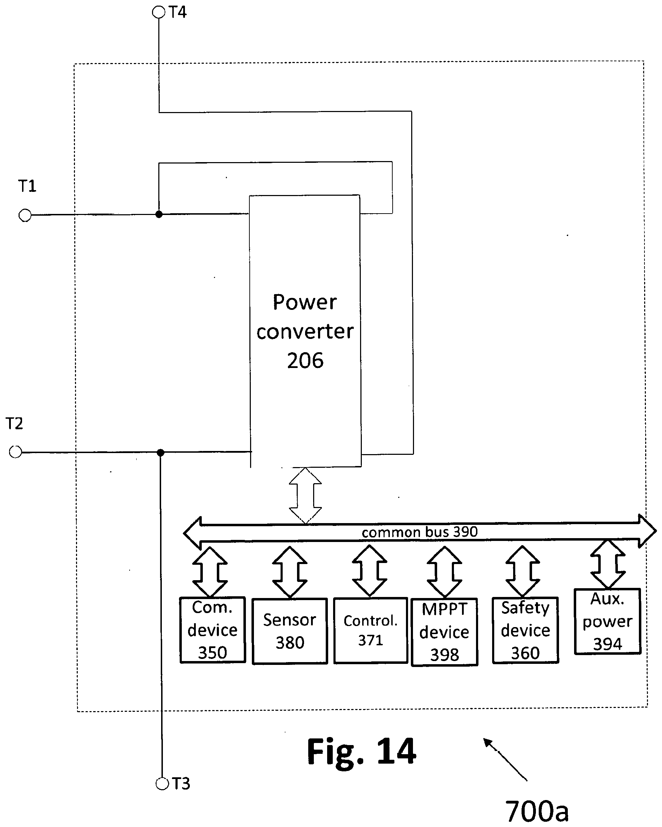

Reference is now made to Fig. 14, which depicts an exemplary embodiment of a power device 700. PV power device 700a may include some or all of the components of integrated block 50, and may be similarly arranged, with the exclusion of a power-generating PV module. Power device 700a may include power converter 206. In some embodiments, the converter 206 may be and/or include one or more components or devices described herein. For example, the converter 206 may be a DC/DC or DC/AC converter, configured to receive a DC input from module 101 and output a DC, time-varying-DC, or AC signal. Power converter 206 may include an isolated converter such as a Flyback or Forward converter (such as described herein), and in some embodiments may include a polarity adjustment circuit (such as described herein).

According to some aspects, the power converter 204 and/or the power converter 206 may be the same as or may be similar to one another. According to some aspects, the power converter 204 and/or the power converter 206 may be the same as or similar to the compensation device 307 and/or to the power device 700. According to some aspects, the compensation device 307 and/or the power device 700 may be the same as or similar to the power converter 204 and/or the power converter 206.

Referring back to Fig. 14, power device 700a may include circuits and devices discussed herein, such as circuits and devices discussed with regard to other embodiments and figures (e.g. bipolar compensator 307e and/or integrated block 50) such as communication device 350, sensor(s) 380, controller 371, MPPT device 398, safety device(s) 360, auxiliary power circuit 394, and/or common bus 390 (or one or more other bus components). PV power device 700a may include a pair of input terminals T1 and T2 configured to receive DC power from, for example, a photovoltaic module and/or another power source. In some embodiments, the power device may include terminals T3 and T4, configured to be serially coupled to similar power devices. In some embodiments, T3 and T4 are coupled at the time of manufacturing to conductors leading to similar power devices. By coupling a plurality of power devices at the time of manufacturing, using conductors of appropriate length to allow adjacently-coupled power devices to be coupled to adjacent PV modules when deployed in a solar installation, the plurality of power devices 6 can be quickly and efficiently deployed during installation. For example, if two adjacent photovoltaic modules are placed such that their junction boxes are 1.5 meters apart, each pair of PV power devices 6 may be coupled by a conductor approximately 1.5 meters long, with a plurality of such coupled devices forming a "chain" that can be rapidly coupled to all the PV modules in the string.

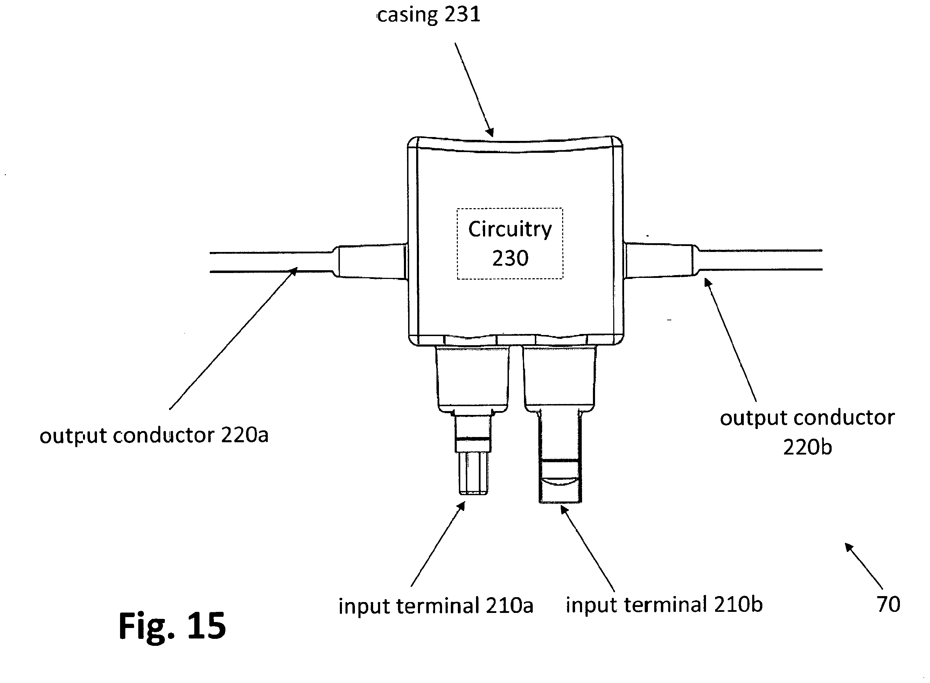

Reference is now made to Fig. 15, which shows an external view of an exemplary photovoltaic power device 70, which may be similar to the power devices described herein. PV power device 70 may comprise casing 231. Circuitry 230 (e.g., which may be any of the circuitry described or referred to herein, such as device 307, device 700, device 50, power converters, etc.) may be enclosed in casing 231 and may include all or some of the power devices described with regard to compensation circuits and/or PV power devices, such as a DC/DC and/or DC/AC converter, communication device(s), sensor(s), controller(s), MPPT device(s), safety device(s), auxiliary power circuit(s) and/or common bus(es). In some embodiments, casing 231 might not comprise a full enclosure. For example, casing 231 may comprise a lid-like surface designed to be placed on a PV module junction box and mechanically connected to the junction box, such that circuitry 230 mounted on the lid is electronically coupled to the PV module when the lid is fastened to the junction box. PV power device 70 may include input terminals 210a and 210b configured to receive power from one or more photovoltaic modules and transfer it to circuitry 230, and a pair of output conductors 220a and 220b configured to output power to the photovoltaic string. In accordance with exemplary embodiments disclosed herein, one of the input terminals may be internally (i.e. within casing 231) coupled to one of the output conductors, allowing current to flow directly from an input terminal to an output conductor while bypassing the power-processing devices of circuitry 230. The output conductors may be coupled to additional PV power devices similar to device 70, forming a chain of power devices, and may be of appropriate length to allow adjacent devices in the device chain to be coupled to adjacent modules in a photovoltaic installation.

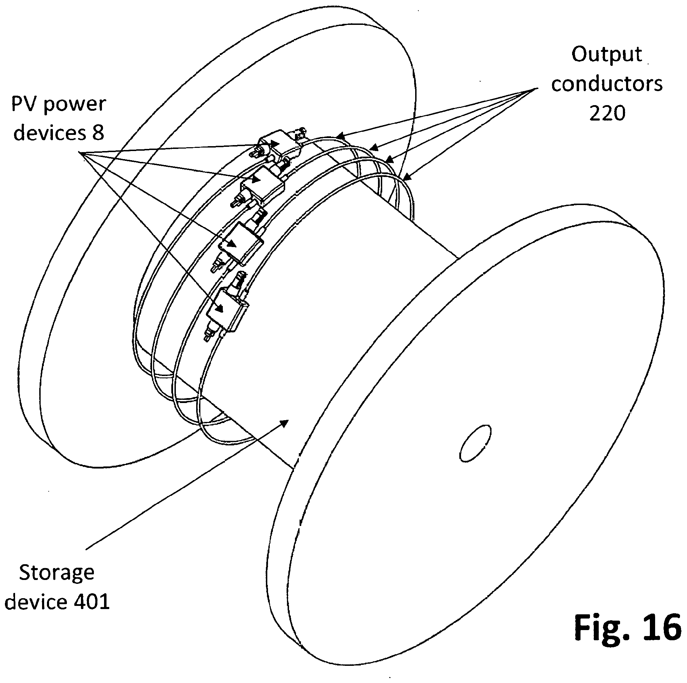

Reference is now made to Fig. 16, which illustrates an aspect of an exemplary embodiment. A plurality of photovoltaic devices 8 may be coupled by output conductors 220, forming a chain of devices 8. Each PV device 8 may be any of, of similar function of, and/or of similar structure of one or more of the devices disclosed herein, such as device 307, device 700, device 50, power converters, etc. Output conductors 220 may each be of appropriate length to allow adjacent devices 8 in the device to be coupled to adjacent modules in a photovoltaic installation. The chain of devices may be efficiently and effectively stored. For example, the chain of devices 8 and output conductors 220 may be wound around storage device 401, which may resemble a cabling reel, allowing the storage device to be rolled along a plurality of PV modules while coupling devices from the chain to the modules.

The indefinite articles "a", "an" is used herein, such as "a string", "a voltage-compensation circuit" have the meaning of "one or more" that is "one or more strings" or "one or more voltage-compensation circuits".

It is noted that various connections are set forth between elements herein. These connections are described in general and, unless specified otherwise, may be direct or indirect; this specification is not intended to be limiting in this respect. Further, elements of one embodiment may be combined with elements from other embodiments in appropriate combinations or subcombinations.

Although selected features of the present invention have been shown and described, it is to be understood the present invention is not limited to the described features. Instead, it is to be appreciated that changes may be made to these features without departing from the principles of the invention, the scope of which is defined by the claims.

## Claims

1.   A system comprising:

a plurality of photovoltaic strings having a first end connected to a first DC bus and a second end connected to a second DC bus, each photovoltaic string comprising:

a first photovoltaic module (101z);
a plurality of photovoltaic modules (101p, 101n) that are connected to one another in series to form a serial string, wherein the photovoltaic module at a first end of the serial string is connected to the first photovoltaic module (101z) and the photovoltaic module at the second end of the serial string is connected to the second DC bus;

characterized in that each photovoltaic string further comprises
a single power device (307-n) comprising:

first and second input terminals of the power device connected across the first photovoltaic module (101z);
an isolated DC/DC converter including a transformer (T3), with first and second input terminals connected to the first and second input terminals of the power device;
a full-bridge of switches (Q3, Q4, Q5, Q6) disposed between first and second output terminals of the isolated DC/DC converter and first and second output terminals of the power device, and controllable to provide an output voltage to the first and second output terminals of the power device that is either positive or negative;
and wherein each photovoltaic string further comprises
a direct bypass path (B1n) directly connecting the first input terminal of the power device and the first output terminal of the power device;
wherein the power device is configured to:

process a portion of the power produced by the first photovoltaic module by directing a first current flow from the first input terminal of the power device to the first output terminal of the power device via the power device; and
transfer directly to the first output terminal of the power device the rest of the power by directing a second current flow from the first input terminal of the power device to the first output terminal of the power device via the direct bypass path (B1n);
wherein the second input terminal of the power device is directly connected to the photovoltaic module at the first end of the serial string via a direct path;
wherein the second output terminal of the power device is connected to the first DC bus;

wherein the power device is further configured to process said portion of power that is input to the first input terminal of the power device and output a voltage at the second output terminal of the power device to bring the total string voltage of the photovoltaic string to a controlled voltage between the first and second DC buses, wherein the controlled voltage is common to the plurality of photovoltaic strings.

2. The system of claim 1, further comprising: a sensor (380) configured to detect at least one parameter associated with one of the plurality of photovoltaic strings, wherein the power device of said one of the plurality of photovoltaic strings is configured to adjust a compensation voltage based on the at least one detected parameter.

3. The system of claim 2, wherein the at least one detected parameter includes a current or a voltage of said one of the plurality of photovoltaic strings.

4. The system of any one of claims 1 to 3, wherein the second current flow is greater than the first current flow.

5. The system of claim 1, further comprising an inverter configured to convert a direct current, DC, input from the first and second DC buses to an alternating current, AC, output.

**Patentansprüche**

1. System, umfassend:

eine Mehrzahl von Photovoltaik-Strings, deren erstes Ende mit einem ersten DC-Bus verbunden ist und deren zweites Ende mit einem zweiten DC-Bus verbunden ist, wobei jeder Photovoltaik-String umfasst:

ein erstes Photovoltaik-Modul (101z); eine Mehrzahl von Photovoltaik-Modulen (101p, 101n), die miteinander in Reihe geschaltet sind, um einen seriellen String zu bilden, wobei das Photovoltaik-Modul an einem ersten Ende des seriellen Strings mit dem ersten Photovoltaik-Modul (101z) verbunden ist und das Photovoltaik-Modul am zweiten Ende des seriellen Strings mit dem zweiten DC-Bus verbunden ist;

**dadurch gekennzeichnet, dass** jeder Photovoltaik-String ferner umfasst:

eine einzige Leistungsvorrichtung (307-n), umfassend:

einen ersten und einen zweiten Eingangs-Anschluss der Leistungsvorrichtung, die über das erste Photovoltaik-Modul (101z) hinweg angeschlossen sind;
einen isolierten Gleichstromwandler, der einen Transformator (T3) aufweist, wobei ein erster und ein zweiten Eingangsanschluss mit dem ersten und dem zweiten Eingangsanschluss der Leistungsvorrichtung verbunden sind;
eine Vollbrücke von Schaltern (Q3, Q4, Q5, Q6), die zwischen dem ersten und dem zweiten Eingangsanschluss des isolierten Gleichstromwandlers und dem ersten und dem zweiten Ausgangsanschluss der Leistungsvorrichtung angeordnet sind, und dazu steuerbar sind, eine Ausgangsspannung an den ersten und den zweiten Ausgangsanschluss der Leistungsvorrichtung zu liefern, die entweder positiv oder negativ ist;

und wobei jeder Photovoltaik-String ferner umfasst:

einen direkten Bypass-Pfad (B1n), der den ersten Eingangsanschluss der Leistungsvorrichtung und den ersten Ausgangsanschluss der Leistungsvorrichtung direkt miteinander verbindet;

wobei die Leistungsvorrichtung dazu konfiguriert ist:

einen Teil der von dem ersten Photovoltaik-Modul erzeugten Leistung zu verarbeiten durch Richten eines ersten Stromflusses von dem ersten Eingangsanschluss der Leistungsvorrichtung an den ersten Ausgangsanschluss der Leistungsvorrichtung über die Leistungsvorrichtung; und
den Rest der Leistung direkt an den ersten Ausgangsanschluss der Leistungsvorrichtung zu übertragen durch Richten eines zweiten Stromflusses von dem ersten Eingangsanschluss der Leistungsvorrichtung an den ersten Ausgangsanschluss der Leistungsvorrichtung über den direkten Bypass-Pfad (B1n);

wobei der zweiten Eingangsanschluss der Leistungsvorrichtung über einen direkten Pfad mit dem Photovoltaik-Modul an dem ersten Ende des seriellen Strings direkt verbunden ist;
wobei der zweite Ausgangsanschluss der Leistungsvorrichtung mit dem ersten DC-Bus verbunden ist;

wobei die Leistungsvorrichtung ferner dazu konfiguriert ist, den Teil der Leistung zu verarbeiten, der in den ersten Eingangsanschluss der Leistungsvorrichtung eingegeben wird, und eine Spannung an dem zweiten Ausgangsanschluss der Leistungsvorrichtung auszugeben, um die Gesamt-String-Spannung des Photovoltaik-Strings auf eine gesteuerte Spannung zwischen dem ersten und dem zweiten DC-Bus zu bringen, wobei die gesteuerte Spannung eine für die Mehrzahl von Photovoltaik-Strings gemeinsame Spannung ist.

2. System gemäß Anspruch 1, ferner umfassend: einen Sensor (380), der dazu konfiguriert ist, mindestens einen Parameter zu erfassen, der einem der Mehrzahl von Photovoltaik-Strings zugeordnet ist, wobei die Leistungsvorrichtung des einen der Mehrzahl von Photovoltaik-Strings dazu konfiguriert ist, eine Ausgleichsspannung auf Basis des mindestens einen erfassten Parameters einzustellen.

3. System gemäß Anspruch 2, wobei der mindestens eine erfasste Parameter eine Stromstärke oder eine Spannung des einen der Mehrzahl von Photovoltaik-Strings aufweist.

4. System gemäß einem der Ansprüche 1 bis 3, wobei der zweite Stromfluss stärker als der erste Stromfluss ist.

5. System gemäß Anspruch 1, ferner umfassend einen Inverter, der dazu konfiguriert ist, einen von dem ersten und dem zweiten DC-Bus eingegebenen Gleichstrom, DC, in einen ausgegebenen Wechselstrom, AC, umzuwandeln.

**Revendications**

1. Un système comprenant :

une pluralité de chaînes photovoltaïques ayant une première extrémité connectée à un premier bus en courant continu et une deuxième extrémité connectée à un deuxième bus en courant continu, chaque chaîne photovoltaïque comprenant :

un premier module photovoltaïque (101z) ; une pluralité de modules photovoltaïques (101p, 101n) qui sont connectés les uns aux autres en série pour former une chaîne en série, le module photovoltaïque à une première extrémité de la chaîne en série étant connecté au premier module photovoltaïque (101z) et le module photovoltaïque à la deuxième extrémité de la chaîne en série est connectée au deuxième bus en courant continu ;

**caractérisé en ce que** chaque chaîne photovoltaïque comprend en outre un unique dispositif de puissance (307-n) comprenant :

des première et deuxième bornes d'entrée du dispositif de puissance connectées aux bornes du premier module photovoltaïque (101z) ; un convertisseur CC/CC isolé comprenant un transformateur (T3), avec des première et deuxième bornes d'entrée connectées aux première et deuxième bornes d'entrée du dispositif de puissance ; un pont complet de commutateurs (Q3, Q4, Q5, Q6) disposé entre des première et deuxième bornes de sortie du convertisseur CC/CC isolé et des première et deuxième bornes de sortie du dispositif de puissance, et pouvant être commandé pour fournir une tension de sortie à la première et à la deuxième bornes de sortie du dispositif de puissance qui sont soit positives soit négatives ; et dans lequel chaque chaîne photovoltaïque comprend en outre un chemin de dérivation direct (B1n) connectant directement la première borne d'entrée du dispositif de puissance et la première borne de sortie du dispositif de puissance ; dans lequel le dispositif de puissance est configuré pour :

traiter une partie de l'énergie produite par le premier module photovoltaïque en dirigeant un premier flux de courant depuis la première borne d'entrée du dispositif de puissance vers la première borne de sortie du dispositif de puissance via le dispositif de puissance ; et transférer directement à la première borne de sortie du dispositif de puissance le reste de l'énergie en dirigeant un deuxième flux de courant depuis la première borne d'entrée du dispositif de puissance vers la première borne de sortie du dispositif de puissance via le chemin de dérivation directe (B1n) ; dans lequel la deuxième borne d'entrée du dispositif de puissance est directement connectée au module photovoltaïque au niveau de la première extrémité de la chaîne en série via un chemin direct ; dans lequel la deuxième borne de sortie du dispositif de puissance est connectée au premier bus en CC ;

dans lequel le dispositif de puissance est en outre configuré pour traiter ladite partie de l'énergie qui est entrée au niveau de la première borne d'entrée du dispositif de puissance et fournit en sortie une tension à la deuxième borne de sortie du dispositif de puissance pour amener la tension de chaîne totale de la chaîne photovoltaïque à une tension commandée entre les premier et deuxième bus en courant continu, la tension commandée étant commune à la pluralité de chaînes photovoltaïques.

2. Système selon la revendication 1, comprenant en outre : un capteur (380) configuré pour détecter au moins un paramètre associé à l'une parmi la pluralité de chaînes photovoltaïques, dans lequel le dispositif de puissance de ladite une de la pluralité de chaînes photovoltaïques est configuré pour ajuster une tension de compensation basée sur au moins un paramètre détecté.

3. Système selon la revendication 2, dans lequel le au moins un paramètre détecté comprend un courant ou une tension de ladite une de la pluralité de chaînes photovoltaïques.

4. Système selon l'une quelconque des revendications 1 à 3, dans lequel le deuxième flux de courant est supérieur au premier flux de courant.

5. Système selon la revendication 1, comprenant en outre un onduleur configuré pour convertir une entrée en courant continu, CC, à partir des premier et deuxième bus CC en une sortie de courant alternatif, CA.

*Fig. 1 Conventional art*

Fig. 2
Conventional art

Fig. 3a

*Fig. 3b*

Fig. 3c

Fig. 3d

402 Connect in series a voltage-compensation circuit within string(s)

404 Monitor power

406 Power maximised?

No

Yes

408 Configure a compensation voltage

410 Add the compensation voltage to voltage of string

400

*Fig. 4*

Power bus

string 316a

Vs_a | 307-1

101m

101b

101a

string 316n

Vs_n | 307-n

101z

101p

101n

301

**Fig. 5**     Ground bus

100

**Fig. 6A**

213

307c

**Fig. 6B**

212

307d

Fig. 7

EP 3 433 914 B1

630

Q1  Q2

Q3  Q4

Vout+

Vout-

rectifier circuit 610

307f

**Fig. 8**

**Fig. 9**   Ground bus   200

string 318a

power bus

string 318n

bypass B1n

bypass B1a

307-1

307-n

101m

101z

301

101b

101p

101a

101n

**Fig. 10**

Ground bus

300

Is

Is

Ip

Id

Vin+

Ici

L1

Ci

L2

Q2

Vout-

Is

PV
module
101

Q1

Co

Is

Vin-

Ip

Id

Vout+

Is

307g

**Fig. 11A**

String conductor
631

Is

Is

Ip

Id

Vin+

Ici L1

Ci

PV modul e 101

Q2 Vout-

L2

Ico

IL2

Q1

Co

Is

Ip Ici Vin-

Vout+

Is

307g

## Fig. 11B

String conductor 631

power bus

string 319a

string 319n

| 101m | 700m |
| 101b | 700b |
| 101a | 700a |

| 101z | 700z |
| 101p | 700p |
| 101n | 700n |

710

**Fig. 12**

Ground bus

400

**Fig. 13**

50

○T4

T1

○

Power
converter
206

T2

○

⇕

common bus 390

⇕          ⇕          ⇕          ⇕          ⇕          ⇕

| Com.<br>device<br>350 | Sensor<br>380 | Control.<br>371 | MPPT<br>device<br>398 | Safety<br>device<br>360 | Aux.<br>power<br>394 |

**Fig. 14**

700a

○T3

Fig. 15

Fig. 16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2010002960 A
- US 2013193765 A
- US 2010126550 A
- US 2015364918 A

### Non-patent literature cited in the description

- **HUIMIN ZHOU et al.** PV Balancers: Concept, Architectures, and Realization. *IEEE TRANSACTIONS ON POWER ELECTRONICS, USA,* vol. 30 (7), ISSN 0885-8993, 3479-3487
- PV balancers: Concept, architectures, and realization. **HUIMIN ZHOU et al.** ENERGY CONVERSION CONGRESS AND EXPOSITION (ECCE), 2012 IEEE. IEEE, 3749-3755